# EUROPÄISCHE PATENTSCHRIFT

(11) **EP 0 962 361 B1**
(45) Veröffentlichungstag und Bekanntmachung des Hinweises auf die Patenterteilung: **05.04.2006**
(21) Anmeldenummer: 99201661.8
(22) Anmeldetag: 26.05.1999
(51) Int. Cl.: B60R 16/02

(54) **Elektronisches Gerät mit einer erschütterungsempfindlichen Baueinheit**
Electronic apparatus with a vibration sensitive unit
Appareil électronique comprenant une unité sensible aux vibrations

(30) Priorität: 30.05.1998 DE 19824378
(43) Veröffentlichungstag der Anmeldung: 08.12.1999
(73) Patentinhaber: Philips Intellectual Property & Standards GmbH, 20099 Hamburg (DE); Koninklijke Philips Electronics, N.V., 5621 BA Eindhoven (NL)
(72) Erfinder: Hopf, Christian, 22335 Hamburg (DE); Kunze, Norbert, 22335 Hamburg (DE); Müller, Stefan, 22335 Hamburg (DE); Rumpf, Horst, 22335 Hamburg (DE); Wouters, Cornelius, 22335 Hamburg (DE)
(74) Vertreter: Volmer, Georg

(56) Entgegenhaltungen:
- EP-A- 0 288 126
- EP-A- 0 583 946
- FR-A- 2 531 561
- US-A- 3 263 953
- US-A- 4 633 973
- US-A- 4 722 505

## Beschreibung

Die Erfindung bezieht sich auf ein elektronisches Gerät mit einer erschütterungsempfindlichen Baueinheit, die in einem Gehäuse angeordnet ist, wobei das Gehäuse und die erschütterungsempfindliche Baueinheit mittels Dämpfungsmitteln gekoppelt sind.

Ein derartiges elektronisches Gerät ist beispielsweise aus der DE 39 14 303 A1 bekannt. Zur Entkopplung von äußeren Vibrationen und/oder Erschütterungen zwischen Geräte-Chassis bzw. Laufwerk und Halterung bzw. Gehäuse des Gerätes sind in diesem bekannten Gerät Schraubenfedern mit linearer Federkraft-Kennlinie vorgesehen. Die Schwingungsamplitude derartiger Schraubenfedern ist bei niederfrequenter Schwingungsanregung größer als bei hochfrequenter Schwingungsanregung. Der Schwingungsraum der erschütterungsempfindlichen Baueinheit muß daher in solchen Geräten hinsichtlich der niedrigsten im Betrieb auftretenden Anregungsfrequenzen ausgelegt werden.

Außerdem ist aus der US3,263,953 eine Befestigung für einen Tonträger bekannt, welcher Erschütterungen auffängt. Hierzu sind konische Federn mit unterschiedlichen Durchmessern vorgesehen, die senkrecht zu einem Plattenteller angebracht sind. Auf diese Weise wird ein Effekt unterschiedlicher Steifheit der Federn bei unterschiedlicher Belastung der Federn erreicht, d.h. das Verhältnis der Last auf die Federn auf die Auslenkung der Federn ist veränderlich.

Ferner offenbart die US4,633,973 ein gattungsgemäßes akustisches Gerät, das einen Haltemechanismus mit elastischen Elementen, Spiralfedern, aufweist, wobei ein elastisches Element Erschütterungen, welche gegen eine Wiedergabeeinrichtung wirken, auffängt. Insbesondere werden auch Scherkräfte senkrecht zur Ausrichtung der Spiralfedern aufgefangen, außerdem können die Spiralfedern auch schräg zur Wiedergabeeinrichtung angeordnet werden.

Es ist Aufgabe der Erfindung, ein elektronisches Gerät der eingangs genannten Art zu schaffen, bei dem der erforderliche Schwingungsraum der erschütterungsempfindlichen Baueinheit reduziert wird. Außerdem ist eine Aufgabe der Erfindung, eine geeignete Dämpfung gegen Erschütterungen für ein elektronisches Gerät bereitzustellen.

Diese Aufgabe ist erfindungsgemäß dadurch gelöst, daß ein elektronisches Gerät mit einer erschütterungsempfindlichen Baueinheit bereitgestellt ist, die in einem Gehäuse angeordnet ist, wobei das Gehäuse und die erschütterungsempfindliche Baueinheit mittels Dämpfungsmitteln gekoppelt sind, wobei als Dämpfungsmittel wenigstens eine Federanordnung vorgesehen ist, die eine progressive Federkennlinie aufweist, welche dadurch zustande kommt, daß die Federanordnung eine Schraubenfeder mit nichtlinearem Windungsabstand aufweist, und daß innerhalb der Schraubenfeder ein Federkern angeordnet ist, wobei die Schraubenfeder und der Federkern so ausgebildet sind, daß der radiale Abstand zwischen den Windungen der Schraubenfeder und dem Federkern nicht konstant ist.

Unter einer progressiven Federkennlinie wird verstanden, daß die Federkraft mit zunehmender Schwingungsamplitude progressiv, d.h. überproportional, zunimmt.

Die Erfindung weist eine Schraubenfeder mit nichtlinearem Windungsabstand auf Dieser nichtlineare Windungsabstand bewirkt eine nichtlineare progressive Federkennlinie der Schraubenfeder in axialer Richtung der Schraubenfeder. Innerhalb der Schraubenfeder ist ein Federkern angeordnet, wobei der radiale Abstand zwischen den Windungen der Schraubenfeder und dem Federkern nicht konstant ist. Dadurch wird bewirkt, daß mit zunehmender Schwingungsamplitude ein immer größerer Anteil der Windungen der Schraubenfeder an dem Federkern zur Anlage kommt, wodurch die Schwingungen mit zunehmender Schwingungsamplitude progressiv gedämpft werden und sich in den radial zu der Schraubenfeder erstreckenden Raumrichtungen eine progressive Federkennlinie ergibt.

Bei einer Ausführungsform der Erfindung erfolgt mittels der in drei Raumrichtungen progressiven Federkennlinie in allen drei Raumrichtungen eine progressive Dämpfung auftretender Schwingungen. Unter den drei Raumrichtungen werden Raumrichtungen eines kartesischen Koordinatensystems verstanden. Eine Achse dieses kartesischen Koordinatensystems ist dabei vorzugsweise in Richtung der Längsachse der Federanordnung angeordnet. Die auftretenden Schwingungen werden somit dreidimensional progressiv gedämpft.

Die Schwingungsamplitude der niederfrequenten Schwingungen wird durch die nichtlineare Abstimmung der Feder mit progressiver Federkennlinie verkleinert. Dadurch wird der notwendige Schwingungsraum der erschütterungsempfindlichen Baueinheit in allen drei Raumrichtungen und damit der Bauraum des elektronischen Gerätes in allen drei Raumrichtungen verkleinert.

Bei der vorteilhaften Ausgestaltung der Erfindung gemäß Anspruch 3 ist der Federkern fest mit dem Gehäuse verbunden. Der radiale Abstand zwischen den Windungen der Schraubenfeder und dem Federkern nimmt von dem Gehäuse in Richtung auf die erschütterungsempfindliche Baueinheit zu, d.h. in der Nähe des Gehäuses ist der Abstand zwischen den Windungen der Schraubenfeder und dem Federkern relativ klein, während er in der Nähe der erschütterungsempfindlichen Baueinheit relativ groß ist. Bei Schwingungen der erschütterungsempfindlichen Baueinheit kommt daher mit zunehmender Schwingungsamplitude die Schraubenfeder zunächst an dem sich in der Nähe des Gehäuses befindlichen Teil des Federkerns zur Anlage. Mit zunehmender Schwingungsamplitude kommt dann ein immer größerer Anteil der Windungen der Schraubenfeder an dem Federkern zur Anlage, wodurch sich in den radial zu der Schraubenfeder erstreckenden Raumrichtungen eine progressive Federkennlinie und somit eine progressive Dämpfung der Schwingungsamplitude ergibt.

Bei der vorteilhaften Ausgestaltung gemäß Anspruch 4 ist der Federkern mit der erschütterungsempfindlichen Baueinheit verbunden und schwingt daher mit der erschütterungsempfindlichen Baueinheit mit. Der radiale Abstand zwischen den Windungen der Schraubenfeder und dem Federkern nimmt bei dieser Ausführungsform von dem Gehäuse in Richtung auf die erschütterungsempfindliche Baueinheit ab, d.h. in der Nähe der erschütterungsempfindlichen Baueinheit ist der Abstand zwischen den Windungen der Schraubenfeder und dem Federkern relativ klein, während er in der Nähe des Gehäuses relativ groß ist. Bei auftretenden Schwingungen der erschütterungsempfindlichen Baueinheit kommen daher mit zunehmender Schwingungsamplitude zunächst nur die Windungen der Schraubenfeder mit dem Federkern zur Anlage, die sich in der Nähe der erschütterungsempfindlichen Baueinheit befinden. Mit zunehmender Schwingungsamplitude kommt dann ein immer größerer Anteil der Windungen der Schraubenfeder mit dem Federkern zur Anlage, wodurch sich eine in radialer Richtung progressive Federkennlinie und somit eine progressive Dämpfung der Schwingungsamplituden der erschütterungempfindlichen Baueinheit ergeben.

Die erfindungsgemäßen Ausgestaltungen des elektronischen Gerätes lassen sich vorzugsweise in Geräten zum Abspielen oder Beschreiben von optischen Speicherplatten, wie beispielsweise CDs oder DVDs verwenden. Insbesondere ist das erfindungsgemäße elektronische Gerät für den Einbau in Fahrzeuge geeignet, da in Fahrzeugen der zur Verfügung stehende Bauraum begrenzt ist und während der Fahrt eine Vielzahl verschieden-frequenter Schwingungsanregungen auftreten.

Einige schematisch dargestellte Ausführungsbeispiele der Erfindung werden nachfolgend anhand der Zeichnung in den Fig. 1 bis 4 näher erläutert. Es zeigen:
Fig. 1 eine Draufsicht auf ein elektronisches Gerät mit einer erschütterungsempfindlichen Baueinheit, die mittels vier Federanordnungen mit dem Gehäuse des elektronischen Gerätes gekoppelt ist,
Fig. 2 eine Federanordnung mit einer zylindrischen Schraubenfeder mit nichtlinearem Windungsabstand, wobei innerhalb der zylindrischen Schraubenfeder ein an dem Gehäuse befestigter konischer Poderkern befestigt ist,
Fig. 3 eine Federanordnung mit einer zylindrischen Schraubenfeder mit nichtlinearem Windungsabstand, wobei innerhalb der Schraubenfeder ein an der erschütterungsempfindlichen Baueinheit befestigter konischer Federkern angeordnet ist,
Fig. 4 eine Federanordnung mit einer kegelförmigen Schraubenfeder mit nichtlinearem Windungsabstand, wobei innerhalb der kegelförmigen Schraubenfeder ein an dem Gehäuse befestigter konischer Federkern angeordnet ist.

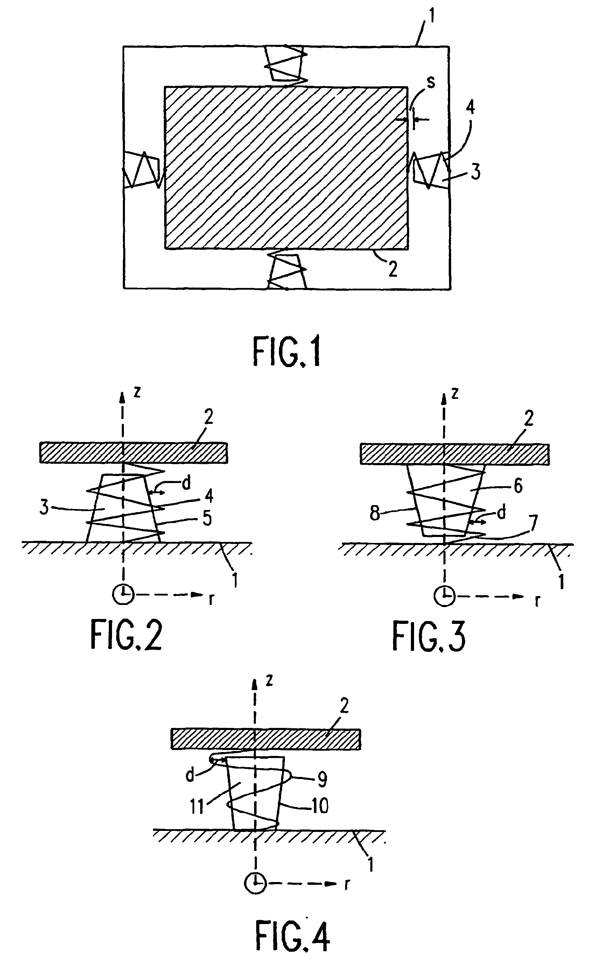

Fig. 1 zeigt eine schematische Draufsicht auf ein elektronisches Gerät, welches ein Gehäuse 1 aufweist, in dem eine erschütterungsempfindliche Baueinheit 2 angeordnet ist. Die erschütterungsempfindliche Baueinheit 2 ist mit dem Gehäuse 1 mittels vier Federanordnungen 3 gekoppelt. Die Federanordnungen 3 weisen jeweils eine zylinderförmige Schraubenfeder 4 auf. Die zylinderförmigen Schraubenfedern 4 weisen einen nichtlinearen Windungsabstand auf, wodurch sich in Richtung der Längsachse der zylinderförmigen Schraubenfedern 4 eine progressive Federkennlinie ergibt. Die zylinderförmigen Schraubenfedern 4 sind einerseits an dem Gehäuse 1 und andererseits an der erschütterungsempfindlichen Baueinheit 2 befestigt. Innerhalb der zylinderförmigen Schraubenfedern 4 ist jeweils ein konischer Federkern 5 angeordnet. Der konische Federkern 5 ist fest mit dem Gehäuse 1 verbunden. Das Ende der konischen Federkerne 5 ist etwas beabstandet von der erschütterungsempfindlichen Baueinheit 2 angeordnet, so daß für die erschütterungsempfindliche Baueinheit 2 jeweils ein Schwingungsraum S zur Verfügung steht. Die Federanordnungen 3 dienen der Entkopplung von äußeren Vibrationen und/oder Erschütterungen zwischen dem Gehäuse 1 und der erschütterungsempfindlichen Baueinheit 2.

Fig. 2 zeigt in vergrößerter Darstellung die gemäß Fig. 1 zwischen dem Gehäuse 1 und der erschütterungsempfindlichen Baueinheit 2 angeordneten Federanordnungen 3. Der Abstand zwischen den einzelnen Windungen der zylinderförmigen Schraubenfeder 4 ist nichtlinear. Im dargestellten Beispiel ist der Windungsabstand in einem Mittelbereich der Schraubenfeder 4 größer als in den Randbereichen der Schraubenfeder 4. Dadurch wird eine progressive Federkennlinie in Richtung der Längsachse Z der Schraubenfeder 4 erzielt. Der Federkern 5 ist konisch zulaufend ausgebildet und verjüngt sich von dem Gehäuse 1 in Richtung auf die erschütterungsempfindliche Baueinheit 2. Dadurch wird erreicht, daß der radiale Abstand d in der radialen Richtung r zwischen den einzelnen Windungen der Schraubenfeder 4 und dem Federkern 5 von dem Gehäuse 1 in Richtung auf die erschütterungsempfindliche Baueinheit 2 zunimmt.

Bei Schwingungen des Gehäuses 1 liegen sich mit zunehmender Schwingungsamplitude die Windungen der Schraubenfeder 4 zunächst in der Nähe des Gehäuses 1 an den konischen Federkern 5 an. Mit zunehmender Schwingungsamplitude kommt ein immer größerer Teil der Windungen der Schraubenfeder 4 an dem Federkern 5 zur Anlage. Dadurch wird erreicht, daß die Schwingungen mit zunehmender Schwingungsamplitude mittels der Pederanordnungen 3 progressiv gedämpft werden und sich somit auch in der radialen Richtung r eine progressive Federkennlinie ergibt. Insgesamt haben die Federanordnungen 3 somit eine in allen drei Raumrichtungen progressive Federkennlinie.

Die Schwingungsamplituden von Schraubenfedern sind bei niederfrequenter Schwingunsanregung größer als bei hochfrequenter Schwingungsanregung. Der notwendige Schwingungsraum S muß daher hinsichtlich der niedrigsten im Betrieb auftretenden Anregungsfrequenzen ausgelegt werden. Das in der Fig. 1 dargestellte elektronische Gerät ist vorzugsweise ein CD- oder DVD-Gerat, das für den Einsatz in einem Fahrzeug vorgesehen ist. In einem Fahrzeug ist der zur Verfügung stehende Bauraum für ein derartiges Gerät naturgemäß begrenzt. Durch die progressive Federkennlinie der Federanordnungen 3 wird die Schwingungsamplitude für die den Bauraum bestimmende niedrigste Schwingungsfrequenz erniedrigt, so daß der Schwingungsraum S und somit insgesamt der Bauraum für das Gehäuse 1 gegenüber Anordnungen mit linearen Federkennlinien verringert werden kann.

Fig. 3 zeigt eine alternative Federanordnung 6 mit einer zylindrischen Schraubenfeder 7. Diese Federanordnung 6 kann ebenfalls zur Entkopplung zwischen dem Gehäuse 1 und der erschütterungsemprindlichen Baueinheit 2 gemäß Fig. 1 verwendet werden. Die zylindrische Feder 7 ist zwischen der erschütterungsempfindlichen Baueinheit 2 und dem Gehäuse 1 fest eingespannt. Innerhalb der zylindrischen Schraubenfeder 7 ist ein konischer Federkern 8 angeordnet, der jedoch im Gegensatz zu der Anordnung gemäß Fig. 2 nicht an dem Gehäuse 1, sondern an der erschütterungsempfindlichen Baueinheit 2 befestigt ist. Der konische Federkern 8 schwingt somit mit der erschütterungsempfindlichen Baueinheit 2 mit. Der Federkern 8 verjüngt sich konisch von der etschütterungsempfindlichen Baueinheit 2 in Richtung auf das Gehäuse 1. Dadurch nimmt der radiale Abstand d in der Richtung r zwischen den Windungen der Schraubenfeder 7 und dem konischen Federkern 8 von dem Gehäuse 1 in Richtung auf die erschütterungsempfindliche Baueinheit 2 ab. Dies hat zur Folge, daß bei Schwingungen der aschütterungsempfindlichen Baueinheit 2 zunächst die sich in der Nähe der erschütterungsempfindlichen Baueinheit 2 befindlichen Windungen der Schraubenfeder 7 an dem Federkern 8 zur Anlage kommen. Mit zunehmender Schwingungsamplitude kommen dann auch die weiter von der erschütterungsempfindlichen Baueinheit 2 entfernt gelegenen Windungen der Schraubenfeder 7 mit dem Federkern 8 zur Anlage, wodurch sich wiederum eine progressive Federkennlinie und damit eine progressive Dämpfung der Schwingungen der erschütterungsempfindlichen Baueinheit 2 in der radialen Richtung r ergeben. In der z-Richtung wird die progressive Federkennlinie entsprechend Fig. 2 dadurch erreicht, daß der Windungsabstand zwischen den einzelnen Windungen der Schraubenfeder 7 in dem Mittelbereich der Schraubenfeder 7 größer ist als in den Randbereichen der Schraubenfeder 7. Somit ergibt sich insgesamt auch für die Federanordnung gemäß Fig. 3 eine in allen drei Raumrichtungen progressive Federkennlinie.

Eine weitere alternative Federanordnung 11 zur Entkopplung zwischen dem Gehäuse 1 und der erschütterungsempfindlichen Baueinheit 2 gemäß Fig. 1 ist in der Fig. 4 schematisch dargestellt. Zwischen dem Gehäuse 1 und der erschütterungsempfindlichen Baueinheit 2 ist eine kegelförmige Schraubenfeder 9 angeordnet und einerseits an der erschütterungsempfindlichen Baueinheit 2 und andererseits an dem Gehäuse 1 befestigt. Der Windungsabstand der kegelförmigen Schraubenfeder 9 ist in z-Richtung nichtlinear, was dadurch erreicht wird, daß der Windungsabstand in dem Mittelbereich der kegelförmigen Schraubenfeder 9 größer ist als in den Randbereichen der kegelförmigen Schraubenfeder 9. Der radiale Durchmesser in der radialen Richtung r der kegelförmigen Schraubenfeder 9 verjüngt sich in Richtung auf das Gehäuse 1, d.h. er ist in der Nähe der erschütterungsempfindlichen Baueinheit 2 größer als in der Nähe des Gehäuses 1. Innerhalb der kegelförmigen Schraubenfeder 9 ist ein konischer Federkern 10 angeordnet, der an dem Gehäuse 1 befestigt ist. Der konische Federkern 10 verjüngt sich in Richtung auf das Gehäuse 1. Der Grad der Verjüngung des konischen Federkern 10 ist so ausgebildet, daß der radiale Abstand d zwischen den Windungen der Schraubenfeder 9 und dem Federkern 10 von dem Gehäuse 1 in Richtung auf die erschütterungsempfindliche Baueinheit 2 zunimmt. Dadurch wird eine progressive Kennlinie der Federanordnung gemäß Fig. 4 in der radialen Richtung r erzielt. Insgesamt ergibt sich eine progressive Federkennlinie in allen drei Raumrichtungen.

Es sind auch weitere Federanordnungen mit verschiedenartigsten Federn und Federkernen möglich, die eine progressive Federkennlinie ergeben. Im wesentlichen kommt es bei allen möglichen Federanordnungen nur darauf an, daß sich der Abstand zwischen den Windungen der Schraubenfeder und dem sich innerhalb der Schraubenfeder befindlichen Federkern nicht konstant ist, so daß mit zunehmender Schwingungsamplitude der erschütterungsempfindlichen Baueinheit 2 ein zunehmender Anteil der Windungen der Schraubenfedern an dem Federkern zur Anlage kommen.

## Patentansprüche

1. Elektronisches Gerät mit einer erschütterungsempfindlichen Baueinheit (2), die in einem Gehäuse (1) angeordnet ist, wobei das Gehäuse (1) und die erschütterungsempfindliche Baueinheit (2) mittels Dämpfungsmitteln (3, 6, 11) gekoppelt sind, wobei als Dämpfungsmittel wenigstens eine Federanordnung (3, 6, 11) vorgesehen ist, **dadurch gekennzeichnet, daß** die Federanordnung (3, 6, 11) eine progressive Federkennlinie aufweist, welche **dadurch** zustande kommt, daß die Federanordnung (3, 6, 11) eine Schraubenfeder (4, 7, 9) mit nichtlinearem Windungsabstand aufweist, und daß innerhalb der Schraubenfeder (4, 7, 9) ein entweder mit dem Gehäuse oder mit der erschütterungsempfindlichen Baueinheit befestigter Federkern (5, 8, 10) angeordnet ist, wobei die Schraubenfeder (4, 7, 9) und der Federkern (5, 8, 10) so ausgebildet sind, daß der radiale Abstand zwischen den Windungen der Schraubenfeder (4, 7, 9) und dem Federkern (5, 8, 10) nicht konstant ist, so daß zunehmender Scwhingungsamplitude der erschütterungsempfindlichen Baueinheit (2) ein zunehmender Anteil der windungen der Schraubenfeder (4, 7, 9) an dem Federkern zur Anlagekommen.

2. Elektronisches Gerät nach Anspruch 1,
**dadurch gekennzeichnet, dass** die Federanordnung (3, 6, 11) eine in drei Raumrichtungen progressive Federkennlinie aufweist.

3. Elektronisches Gerät nach Anspruch 1,
**dadurch gekennzeichnet, daß** der Federkern (5, 10) an dem Gehäuse (1) befestigt ist und daß der radiale Abstand (d) zwischen den Windungen der Schraubenfeder (4, 9) und dem Federkern (5, 10) von dem Gehäuse (1) in Richtung auf die erschütterungsempfindlichen Baueinheit (2) zunimmt.

4. Elektronisches Gerät nach Anspruch 1,
**dadurch gekennzeichnet, daß** der Federkern (8) an der erschütterungsempfindlichen Baueinheit (2) befestigt ist und daß der radiale Abstand (d) zwischen den Windungen der Schraubenfeder (7) und dem Federkern (8) von dem Gehäuse (1) in Richtung auf die erschütterungsempfindliche Baueinheit (2) abnimmt.

5. Elektronisches Gerät nach einem der Ansprüche 1 bis 4,
**dadurch gekennzeichnet, daß** die Feder eine kegelförmige Schraubenfeder (9) mit nichtlinearem Windungsabstand ist.

6. Elektronisches Gerät nach einem der Ansprüche 1 bis 5,
**dadurch gekennzichnet**, daß die Feder eine zylinderförmige Schraubenfeder (4, 7) mit nichtlinearem Windungsabstand ist.

7. Elektronisches Gerät nach einem der Ansprüche 1 bis 6,
**dadurch gekennzeichnet, daß** das Gerät ein Gerät zum Lesen von auf einer optischen Speicherplatte gespeicherten Informationen und/oder zum Schreiben von Informationen auf eine optische Speicherplatte, insbesondere ein CD/DVD-Gerät, ist.

8. Elektronisches Gerät nach einem der Ansprüche 1 bis 7,
**dadurch gekennzeichnet, daß** das elektronische Gerät zum Einbau in ein Fahrzeug vorgesehen ist.

9. Fahrzeug mit einem elektronischen Gerät nach einem der Ansprüche 1 bis 8.

## Claims

1. An electronic apparatus having a vibration-sensitive constructional unit (2) accommodated in a housing (1), the housing (1) and the vibration-sensitive constructional unit (2) being coupled by damping means (3, 6, 11), the damping means comprising at least one spring arrangement (3, 6, 11), **characterized in that** the spring arrangement (3, 6, 11) has a progressive spring characteristic, which is achieved **in that** the spring arrangement (3, 6, 11) comprises a helical spring (4, 7, 9) having non-linearly spaced turns and **in that** a spring core (5, 8, 10), secured either to the housing or to the vibration-sensitive constructional unit, is arranged inside the helical spring (4, 7, 9), the helical spring (4, 7, 9) and the spring core (5, 8, 10) being constructed in such a manner that the radial clearance between the turns of the helical spring (4, 7, 9) and the spring core (5, 8, 10) is not constant, as a result of which an increasing number of turns of the helical spring (4, 7, 9) come into contact with the spring core when the vibration amplitude of the vibration-sensitive constructional unit (2) increases.

2. An electronic apparatus as claimed in Claim 1, **characterized in that** the spring arrangement (3, 6, 11) has a spring characteristic which is progressive in three directions in space

3. An electronic apparatus as claimed in Claim 1, **characterized in that** the spring core (5, 10) is secured to the housing (1) and **in that** the radial clearance (d) between the turns of the helical spring (4, 9) and the spring core (5, 10) increases from the housing (1) in a direction towards the vibration-sensitive constructional unit (2).

4. An electronic apparatus as claimed in Claim 1, **characterized in that** the spring core (8) is secured to the vibration-sensitive constructional unit (2) and **in that** the radial clearance (d) between the turns of the helical spring (7) and the spring core (8) decreases from the housing (1) in a direction towards the vibration-sensitive constructional unit (2).

5. An electronic apparatus as claimed in any one of the Claims I to 4, **characterized in that** the spring is a conical helical spring (9) having non-linearly spaced turns.

6. An electronic apparatus as claimed in any one of the Claims I to 5, **characterized in that** the spring is a cylindrical helical spring (4, 7) having non-linearly spaced turns.

7. An electronic apparatus as claimed in any one of the Claims I to 6, **characterized in that** the apparatus is an apparatus for reading information stored on an optical storage disc and/or writing information on an optical storage disc, particularly a CD/DVD apparatus.

8. An electronic apparatus as claimed in any one of the Claims 1 to 7, **characterized in that** the electronic apparatus is adapted to be built into a motor vehicle.

9. A motor vehicle equipped with an electronic apparatus as claimed in any one of the Claims 1 to 8.

## Revendications

1. Appareil électronique avec une unité (2) sensible aux vibrations qui est disposée dans un boîtier (1), dans lequel le boîtier (1) et l'unité (2) sensible aux vibrations sont couplés à l'aide de moyens amortisseurs (3, 6, 11), au moins un dispositif à ressort (3, 6, 11) étant prévu comme moyen d'amortissement, **caractérisé en ce que** le dispositif à ressort (3, 6, 11) présente une caractéristique progressive d'élasticité qui est formée par le fait que le dispositif à ressort (3, 6, 11) présente un ressort hélicoïdal (4, 7, 9) avec un intervalle non linéaire entre les enroulements et que, dans les ressorts hélicoïdaux (4, 7, 9), est disposé un noyau de ressort (5, 8, 10), soit fixé au boîtier, soit fixé à l'unité sensible aux vibrations, les ressorts hélicoïdaux (4, 7, 9) et le noyau de ressort (5, 8, 10) étant conçus de telle sorte que la distance radiale entre les enroulements des ressorts hélicoïdaux (4, 7, 9) et le noyau de ressort (5, 8, 10) n'est pas constante de telle sorte qu'un nombre croissant des enroulements des ressorts hélicoïdaux (4, 7, 9) soient appliqués contre le noyau de ressort à mesure que l'amplitude d'oscillation de l'unité (2) sensible aux vibrations augmente.

2. Appareil électronique selon la revendication 1,
**caractérisé en ce que** le dispositif à ressort (3, 6, 11) présente une caractéristique d'élasticité progressive dans trois directions de l'espace.

3. Appareil électronique selon la revendication 1,
**caractérisé en ce que** le noyau de ressort (5, 10) est fixé au boîtier (1) et que la distance radiale (d) entre les enroulements des ressorts hélicoïdaux (4, 9) et le noyau de ressort (5, 10) augmente du boîtier (1) dans la direction de l'unité (2) sensible aux vibrations.

4. Appareil électronique selon la revendication 1,
**caractérisé en ce que** le noyau de ressort (8) est fixé à l'unité (2) sensible aux vibrations et que la distance radiale (d) entre les enroulements des ressorts hélicoïdaux (7) et du noyau de ressort (8) diminue du boîtier (1) dans la direction de l'unité (2) sensible aux vibrations.

5. Appareil électronique selon l'une des revendications 1 à 4,
**caractérisé en ce que** le ressort est un ressort hélicoïdal (9) conique avec un intervalle non linéaire entre les enroulements.

6. Appareil électronique selon l'une des revendications 1 à 5,
**caractérisé en ce que** le ressort est un ressort hélicoïdal (4,7) cylindrique avec un intervalle non linéaire entre les enroulements.

7. Appareil électronique selon l'une des revendications 1 à 6,
**caractérisé en ce que** l'appareil est un appareil de lecture d'informations enregistrées sur un disque optique et/ou de lecture d'informations sur un disque optique, en particulier un appareil CD/DVD.

8. Appareil électronique selon l'une des revendications 1 à 7,
**caractérisé en ce que** l'appareil électronique est prévu pour le montage dans un véhicule.

9. Véhicule avec un appareil électronique selon l'une des revendications 1 à 8.
